# EUROPEAN PATENT APPLICATION

(11) **EP 2 840 646 A1**
(43) Date of publication of application: **25.02.2015**
(21) Application number: 13778045.8
(22) Date of filing: 17.04.2013
(51) Int. Cl.: H01M 14/00, H01L 31/04, H01M 10/44, H02J 7/35

(54) **OPTICAL POWER GENERATION SYSTEM AND ELECTRICAL STORAGE APPARATUS**

(30) Priority: 18.04.2012 JP 2012094981
(71) Applicant: Kabushiki Kaisha Toshiba, Minato-ku Tokyo 105-8001 (JP); Toshiba Materials Co., Ltd., Isogo-Ku Yokohama-Shi Kanagawa 235-8522 (JP)
(72) Inventor: SUZUKI, Keiji, Tokyo 105-8001 (JP); SUZUKI, Koji, Tokyo 105-8001 (JP); NAKA, Tomomichi, Tokyo 105-8001 (JP); AOKI, Katsuaki, Kanagawa 235-8522 (JP); SASAKI, Akito, Kanagawa 235-8522 (JP)
(74) Representative: Kramer Barske Schmidtchen Patentanwälte PartG mbB
(86) International application number: PCT/JP2013/061428
(87) International publication number: WO 2013/157589

(57) **Abstract**

According to an aspect of the invention, there is provided a photovoltaic system including: a power generation module including at least one power generation section configured to convert energy of light to electrical power, and a power storage module including a plurality of power storage devices configured to store the electrical power converted by the power generation section. The power generation module and the power storage module are connected in parallel. In the power storage module, the plurality of power storage devices is connected in series. And, number of the power storage devices is larger than number of the power generation sections.

## Description

### [Technical Field]

Embodiments described herein relate generally to a photovoltaic system and power storage device.

### [Background]

The output of a solar cell is varied with the intensity of received light. Thus, there is a limit to the use of a solar cell as a stand-alone power supply. Accordingly, a solar cell having power storage capability has been proposed.

The solar cell having power storage capability can supply the stored electrical power for a certain period of time after irradiation of the solar cell with light is stopped.

However, the solar cell simply having power storage capability may have poorer I-V characteristics (current-voltage characteristics) than the solar cell having no power storage capability. Furthermore, when irradiation of the solar cell with light is stopped, a sharp drop of output voltage may occur.

### [Prior Art Document]

### [Patent Document]

[Patent Document 1] JP-A 2009-135025

### [Summary of Invention]

### [Technical Problem]

A problem to be solved by the invention is to provide a photovoltaic system and a power storage device having superior I-V characteristics and being capable of suppressing the drop of output voltage upon stoppage of irradiation with light.

### [Technical Solution]

According to an aspect of the invention, there is provided a photovoltaic system including: a power generation module including at least one power generation section configured to convert energy of light to electrical power, and a power storage module including a plurality of power storage devices configured to store the electrical power converted by the power generation section. The power generation module and the power storage module are connected in parallel. In the power storage module, the plurality of power storage devices is connected in series. And, number of the power storage devices is larger than number of the power generation sections.

### [Brief Description of Drawings]

[FIG. 1]

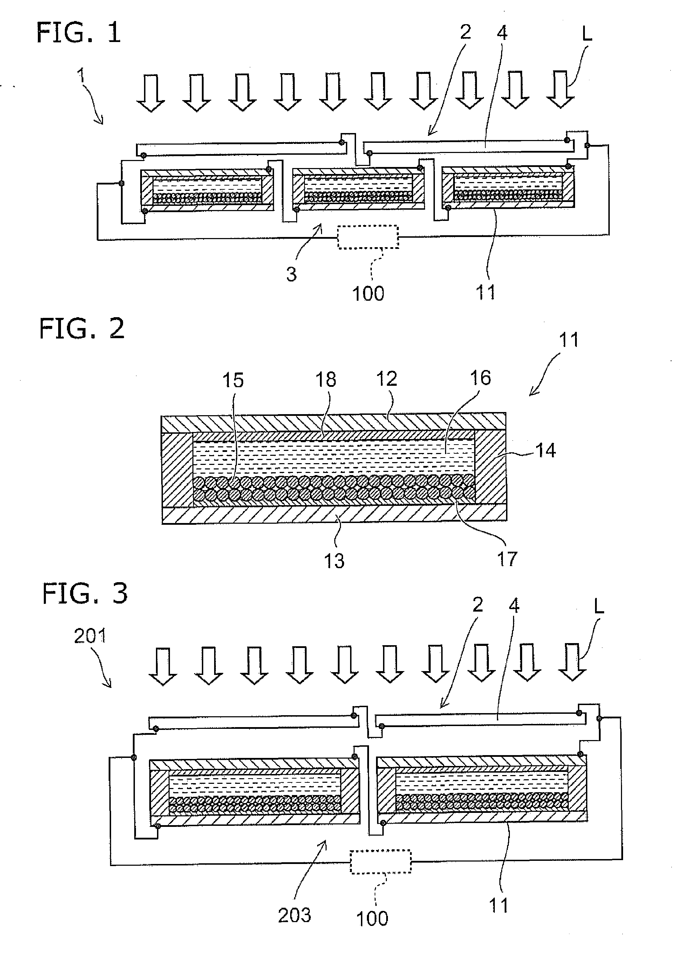

   FIG. 1 is a schematic view for illustrating a photovoltaic system 1 according to this embodiment.
[FIG. 2]
   FIG. 2 is a schematic sectional view for illustrating a power storage device 11 according to this embodiment.
[FIG. 3]
   FIG. 3 is a schematic view for illustrating a photovoltaic system 201 according to a comparative example.
[FIG. 4]

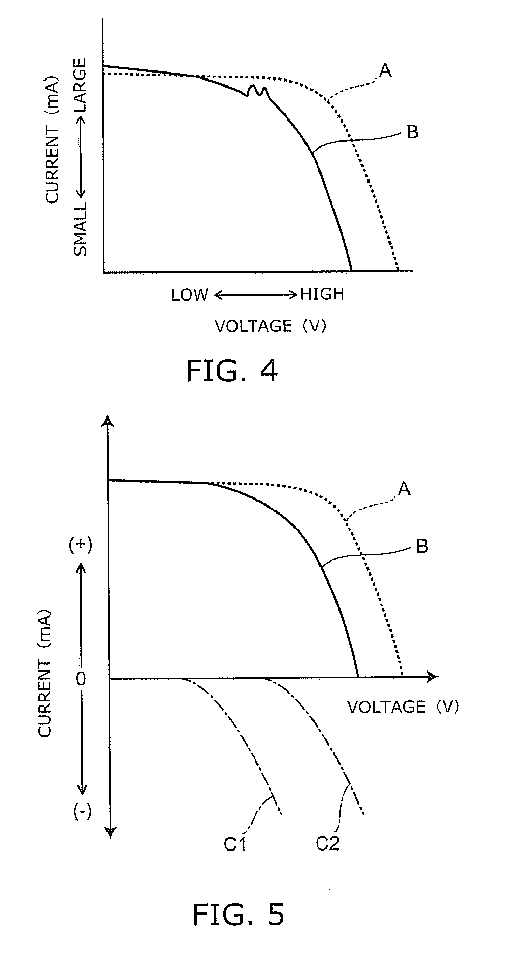

   FIG. 4 is a schematic graph for illustrating I-V characteristics of the photovoltaic system 201 according to the comparative example.
[FIG. 5]
   FIG. 5 is a schematic graph for explaining the factor of the deterioration of the I-V characteristic.
[FIG. 6]

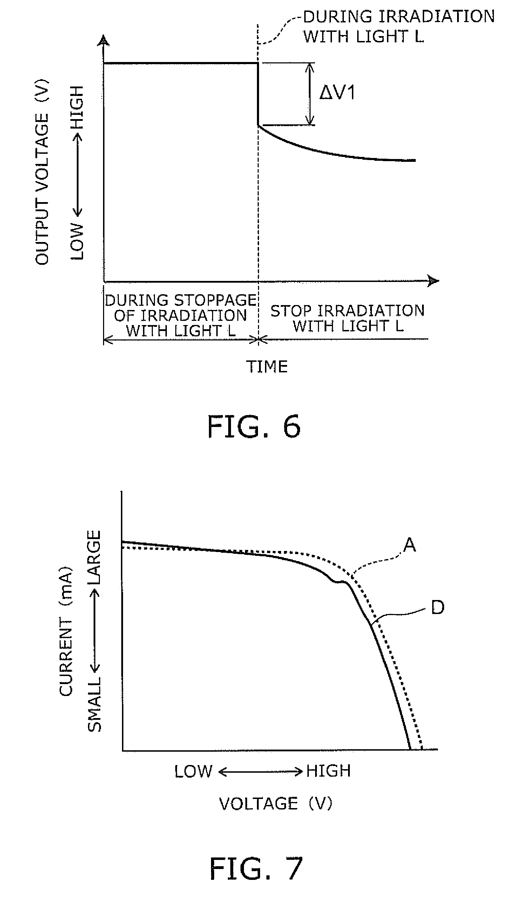

   FIG. 6 is a schematic graph for illustrating the variation of output voltage in the photovoltaic system 201 according to the comparative example.
[FIG. 7]
   FIG. 7 is a schematic graph for illustrating I-V characteristics of the photovoltaic system 1 according to this embodiment.
[FIG. 8]

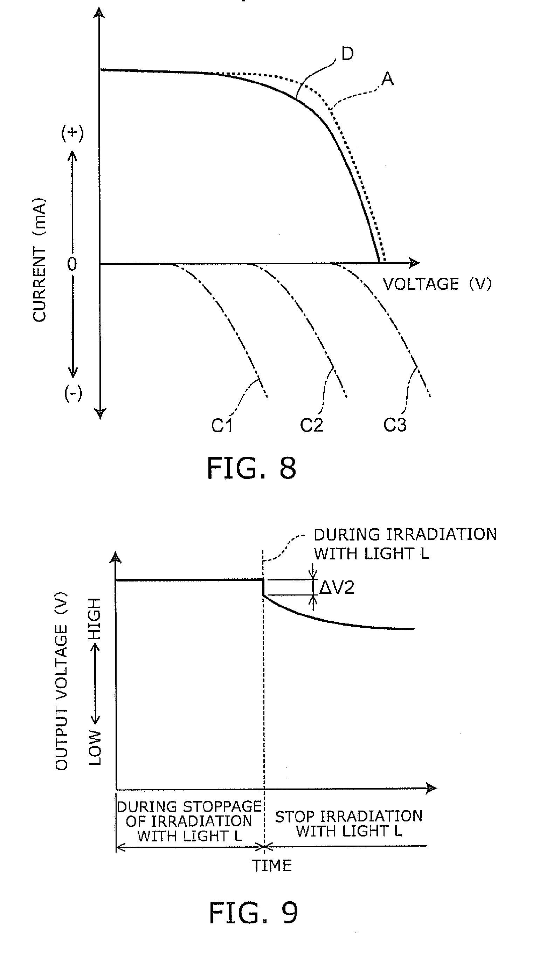

   FIG. 8 is a schematic graph for explaining the factor of the improvement of the I-V characteristic.
[FIG. 9]
   FIG. 9 is a schematic graph for illustrating the variation of output voltage in the photovoltaic system 1 according to this embodiment.
[FIG. 10]

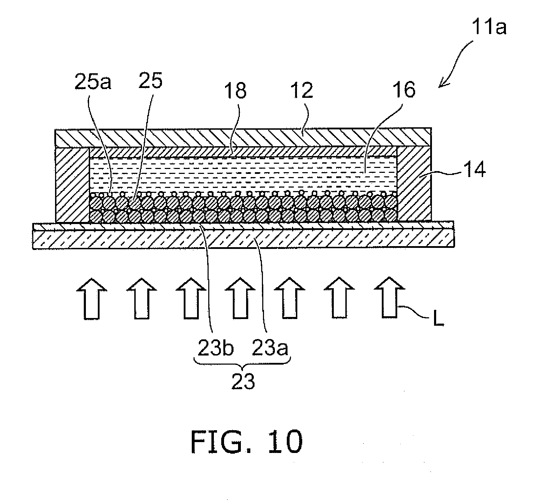

   FIG. 10 is a schematic sectional view for illustrating a power storage device 11a capable of storing and generating electrical power.

### [Mode for Carrying Out the Invention]

Embodiments will now be illustrated with reference to the drawings. In the drawings, similar components are labeled with like reference numerals, and the detailed description thereof is omitted appropriately.

FIG. 1 is a schematic view for illustrating a photovoltaic system 1 according to this embodiment.

FIG. 2 is a schematic sectional view for illustrating a power storage device 11 according to this embodiment.

As shown in FIG. 1, the photovoltaic system 1 according to this embodiment includes a power generation module 2 including at least one power generation section 4, and a power storage module 3 including a plurality of power storage devices 11.

The power generation section 4 converts energy of light L such as sunlight to electrical power by utilizing the photovoltaic effect.

The power generation section 4 can be e.g. a solar cell (also referred as photovoltaic cell and the like).

In the case where the power generation section 4 is a solar cell, the kind of the solar cell is not particularly limited.

Here, in the case where the power generation section 4 is a solar cell, a solar cell panel formed on one transparent substrate (such as glass plate) is counted as one power generation section.

For instance, the power generation section 4 can be a silicon-based solar cell, a compound-based solar cell, an organic solar cell or the like.

Examples of the silicon-based solar cell can be based on e.g. crystalline silicon or amorphous silicon.

Examples based on crystalline silicon can be based on monocrystalline silicon (monocrystalline silicon type), polycrystalline silicon (polycrystalline silicon type), microcrystalline silicon (microcrystalline silicon type) or the like.

Furthermore, crystalline silicon and amorphous silicon can be stacked (hybrid type), or silicon layers different in absorption wavelength range can be stacked (multijunction type).

Examples of the compound-based solar cell can be based on e.g. InGaAs (indium gallium arsenic), GaAs (gallium arsenic), or group I-III-VI compound referred to as chalcopyrite.

Examples of the organic solar cell can include e.g. a solar cell for obtaining photovoltaic power using organic pigments (pigment-sensitized solar cell) and a solar cell for obtaining photovoltaic power using organic thin film semiconductor (organic thin film solar cell).

The power generation section 4 is not limited to those illustrated, but only needs to be able to convert energy of light L such as sunlight to electrical power by utilizing the photovoltaic effect.

Next, the power storage device 11 is described with reference to FIG. 2.

The power storage device 11 stores the electrical power converted by the power generation section 4.

As shown in FIG. 2, the power storage device 11 includes an electrode section 12 (corresponding to an example of the first electrode section), an electrode section 13 (corresponding to an example of the second electrode section), a sealing section 14, a power storage section 15, an electrolyte 16, a protecting section 17, and a reducing section 18.

The electrode section 12 is shaped like a plate and formed form a conductive material.

The electrode section 12 can be formed from e.g. a metal such as aluminum, copper, and stainless steel.

The electrode section 13 is shaped like a plate and provided opposite to the electrode section 12.

The electrode section 13 is formed form a conductive material.

The electrode section 13 can be formed from e.g. a metal such as aluminum, copper, and stainless steel.

In this case, the electrode section 12 and the electrode section 13 can be formed from the same material. Alternatively, the electrode section 12 and the electrode section 13 can be formed from different materials. The material of the electrode section 12 and the electrode section 13 may be translucent as long as being conductive. The electrode section 12 and the electrode section 13 can also be such that e.g. a film made of ITO, IZO (indium zinc oxide), FTO (fluorine-doped tin oxide), SnO₂, InO₃ or the like is formed on a translucent plate-like body. Here, the electrode section 12 and the electrode section 13 can also be configured so that one of the electrode section 12 and the electrode section 13 is translucent and the other is not translucent.

The electrode section 13 on the side provided with the power storage section 15 serves as a negative electrode. The electrode section 12 opposed to the electrode section 13 serving as a negative electrode serves as a positive electrode.

The sealing section 14 is provided between the electrode section 12 and the electrode section 13. The sealing section 14 seals the peripheral portion of the electrode section 12 and the peripheral portion of the electrode section 13.

That is, the sealing section 14 is provided so as to surround the interior of the power storage device 11 along the periphery of the electrode section 12 and the electrode section 13. By joining the electrode section 12 side and the electrode section 13 side, the sealing section 14 hermetically seals the interior of the power storage device 11.

The sealing section 14 can include a glass material.

The sealing section 14 can be formed from e.g. a paste-like glass frit in which powder glass, a binder such as acrylic resin, an organic solvent and the like are mixed.

Examples of the material of the powder glass can include e.g. vanadate-based glass and bismuth oxide-based glass.

In this case, the sealing section 14 can be formed by applying the paste-like glass frit to the to-be-sealed portion and sintering the glass frit. Then, by heating the sealing section 14, the sealing section 14 can be melted to perform sealing. For instance, the formed sealing section 14 can be irradiated with laser light. Thus, sealing can be performed by melting the portion of the sealing section 14 irradiated with laser light.

Here, the sealing section 14 is not limited to those including a glass material.

For instance, the sealing section 14 can include a resin material and can be bonded between the electrode section 12 and the electrode section 13.

The power storage section 15 is provided inside the sealing section 14 on the surface of the electrode section 13 on the side opposed to the electrode section 12.

The power storage section 15 is provided on the electrode section 13 via the protecting section 17.

The power storage section 15 is formed from a material having power storage capability.

The power storage section 15 can be formed from e.g. WO₃ (tungsten oxide).

The power storage section 15 can have a porous structure.

If the power storage section 15 has a porous structure, the contact area with the electrolyte 16 can be increased. This facilitates power storage in the power storage section 15.

The thickness dimension of the power storage section 15 can be set to e.g. approximately 30 µm.

For instance, the power storage section 15 can be formed from particles of WO₃ having a diameter dimension of approximately 20 nm stacked to a thickness of approximately 30 µm.

The thickness of the power storage section 15 is not particularly limited as long as having power storage capability, but preferably 1-100 µm.

The electrolyte 16 is provided inside the sealing section 14.

That is, the electrolyte 16 is packed in the space defined by the electrode section 12, the electrode section 13, and the sealing section 14.

The electrolyte 16 can be e.g. an electrolyte containing iodine. The electrolyte 16 can be made of e.g. lithium iodide and iodine dissolved in a solvent such as acetonitrile.

The protecting section 17 is shaped like a film and provided between the power storage section 15 and the electrode section 13.

The protecting section 17 is provided so as to cover the surface of the electrode section 13 defined by the sealing section 14.

The protecting section 17 is provided in order to suppress corrosion of the electrode section 13 by the electrolyte 16.

Thus, the protecting section 17 is formed from a material having conductivity and chemical resistance to the electrolyte 16.

The protecting section 17 can be formed from e.g. carbon, platinum or the like.

The thickness dimension of the protecting section 17 can be set to e.g. approximately 100 nm.

Here, in the case where the electrode section 13 is formed from a material having chemical resistance to the electrolyte 16, the protecting section 17 is not necessarily needed.

The reducing section 18 is shaped like a film and provided so as to cover the surface of the electrode section 12 defined by the sealing section 14.

The reducing section 18 is provided in order to reduce ions contained in the electrolyte 16. For instance, the reducing section 18 reduces I₃⁻ ions (triiodide ions) contained in the electrolyte 16 to I⁻ ions (iodide ions).

Thus, the reducing section 18 is formed from a material with conductivity, chemical resistance to the electrolyte 16, and reduction of ions contained in the electrolyte 16 taken into consideration.

The reducing section 18 can be formed from e.g. carbon, platinum or the like.

The thickness dimension of the reducing section 18 can be set to e.g. approximately 80 nm.

Next, returning to FIG. 1, the configuration of the photovoltaic system 1 is further illustrated.

As shown in FIG. 1, in the case where a plurality of power generation sections 4 are provided in the power generation module 2, the plurality of power generation sections 4 are connected in series.

Furthermore, the plurality of power storage devices 11 provided in the power storage module 3 are connected in series.

Furthermore, the power generation module 2 and the power storage module 3 are connected in parallel.

To the photovoltaic system 1 in which the power generation module 2 and the power storage module 3 are connected in parallel, a load 100 can be connected.

The layout of the power generation module 2 and the power storage module 3 is not particularly limited.

In this case, light L such as sunlight only needs to be applied to at least the power generation section 4 provided in the power generation module 2.

Thus, as shown in FIG. 1, the power generation module 2 and the power storage module 3 can be stacked, with the power generation module 2 provided on the side irradiated with light L such as sunlight. This can reduce the footprint of the photovoltaic system 1.

Next, the function of the photovoltaic system 1 is illustrated.

If the power generation section 4 provided in the power generation module 2 is irradiated with light L such as sunlight, energy of the light L such as sunlight is converted to electrical power by the power generation section 4.

Part of the electrical power thus converted is supplied to the load 100 and consumed.

Furthermore, part of the converted electrical power is supplied to the power storage device 11 provided in the power storage module 3.

The electrical power supplied to the power storage device 11 is electrochemically stored in the power storage section 15.

When the irradiation of the power generation module 2 with light L such as sunlight is stopped, the conversion of energy of the light L by the power generation section 4 is made inactive.

Then, the electrical power electrochemically stored in the power storage section 15 starts to be supplied to the load 100.

Thus, even when the irradiation of the power generation module 2 with light L such as sunlight is stopped, the load 100 can be supplied with electrical power for a certain period of time.

Here, in the photovoltaic system including the power generation module and the power storage module, the I-V characteristics may be deteriorated. Furthermore, when the irradiation of the power generation module with light L such as sunlight is stopped, a sharp drop of output voltage may occur.

FIG. 3 is a schematic view for illustrating a photovoltaic system 201 according to a comparative example.

As shown in FIG. 3, the photovoltaic system 201 according to the comparative example includes a power generation module 2 including two power generation sections 4, and a power storage module 203 including two power storage devices 11.

Furthermore, the two power generation sections 4 provided in the power generation module 2 are connected in series.

Furthermore, the two power storage devices 11 provided in the power storage module 203 are connected in series.

Furthermore, the power generation module 2 and the power storage module 203 are connected in parallel.

To the photovoltaic system 201 in which the power generation module 2 and the power storage module 203 are connected in parallel, a load 100 can be connected.

FIG. 4 is a schematic graph for illustrating I-V characteristics of the photovoltaic system 201 according to the comparative example.

Symbol A in FIG. 4 refers to the I-V characteristic of only the power generation module 2 in which two power generation sections 4 are connected in series.

Symbol B in FIG. 4 refers to the I-V characteristic of the photovoltaic system 201 in which the power generation module 2 and the power storage module 203 are connected in parallel.

Here, symbols A and B refer to the I-V characteristics in the case where the power generation section 4 is irradiated with light L such as sunlight.

As seen from FIG. 4, the I-V characteristic B of the photovoltaic system 201 according to the comparative example is poorer than the I-V characteristic A of only the power generation module 2.

In this case, the factor of the deterioration of the I-V characteristic can be explained as follows.

FIG. 5 is a schematic graph for explaining the factor of the deterioration of the I-V characteristic.

Symbol A in FIG. 5 refers to the I-V characteristic of only the power generation module 2 in which two power generation sections 4 are connected in series.

Symbol C1 in FIG. 5 refers to the I-V characteristic of one power storage device 11.

Symbol C2 in FIG. 5 refers to the I-V characteristic of only the power storage module 203 in which two power storage devices 11 are connected in series. That is, symbol C2 in FIG. 5 refers to the case where two C1 are added.

Thus, the I-V characteristic B of the photovoltaic system 201 in which the power generation module 2 and the power storage module 203 are connected in parallel is the addition of A in FIG. 5 and C2 in FIG. 5. As a result, the I-V characteristic B of the photovoltaic system 201 according to the comparative example is poorer than the I-V characteristic A of only the power generation module 2.

FIG. 6 is a schematic graph for illustrating the variation of output voltage in the photovoltaic system 201 according to the comparative example.

Here, FIG. 6 shows the variation of the output voltage of the photovoltaic system 201 in which the power generation module 2 and the power storage module 203 are connected in parallel.

As seen from FIG. 6, in the photovoltaic system 201, when the irradiation of the power generation module 2 with light L such as sunlight is stopped, a sharp drop of output voltage (ΔV1) occurs.

FIG. 7 is a schematic graph for illustrating I-V characteristics of the photovoltaic system 1 according to this embodiment.

Symbol A in FIG. 7 refers to the I-V characteristic of only the power generation module 2 in which two power generation sections 4 are connected in series.

Symbol D in FIG. 7 refers to the I-V characteristic of the photovoltaic system 1 in which the power generation module 2 and the power storage module 3 are connected in parallel.

Here, symbols A and D refer to the I-V characteristics in the case where the power generation section 4 is irradiated with light L such as sunlight.

As seen from FIG. 7, the I-V characteristic D of the photovoltaic system 1 according to this embodiment is poorer than the I-V characteristic A of only the power generation module 2.

However, a significant improvement can be achieved over the I-V characteristic B of the photovoltaic system 201 illustrated in FIG. 4.

In this case, the factor of the improvement of the I-V characteristic can be explained as follows.

FIG. 8 is a schematic graph for explaining the factor of the improvement of the I-V characteristic.

Symbol A in FIG. 8 refers to the I-V characteristic of only the power generation module 2 in which two power generation sections 4 are connected in series.

Symbol C1 in FIG. 8 refers to the I-V characteristic of one power storage device 11.

Symbol C2 in FIG. 8 refers to the I-V characteristic in the case where two power storage devices 11 are connected in series.

Symbol C3 in FIG. 8 refers to the I-V characteristic of only the power storage module 3 in which three power storage devices 11 are connected in series. That is, symbol C3 in FIG. 8 refers to the case where three C1 are added.

Thus, the I-V characteristic D of the photovoltaic system 1 in which the power generation module 2 and the power storage module 3 are connected in parallel is the addition of A in FIG. 8 and C3 in FIG. 8.

As a result, the I-V characteristic D of the photovoltaic system 1 according to this embodiment can be significantly improved over the I-V characteristic B of the photovoltaic system 201 according to the comparative example.

FIG. 9 is a schematic graph for illustrating the variation of output voltage in the photovoltaic system 1 according to this embodiment.

As seen from FIG. 9, in the photovoltaic system 1, when the irradiation of the power generation module 2 with light L such as sunlight is stopped, a drop of output voltage (ΔV2) occurs.

However, the drop of output voltage (ΔV2) is smaller than the drop of output voltage (ΔV1) of the photovoltaic system 201 illustrated in FIG. 6.

The reason for this is as follows. The number of power storage devices 11 connected in series is larger by one in the power storage module 3 than in the power storage module 203. Thus, the voltage applied to the power storage module 3 can be made higher.

As described above, in the case where the power generation module 2 and the power storage module 3 are connected in parallel, the number of power storage devices 11 provided in the power storage module 3 is preferably made larger than the number of power generation sections 4 provided in the power generation module 2.

Next, the relationship between the number n of power generation sections 4 provided in the power generation module 2 and the number m of power storage devices 11 provided in the power storage module 3 is further illustrated.

In the power generation module 2, n power generation sections 4 are series connected. The voltage of the electrical power generated by one power generation section 4 is denoted by V. Then, the voltage generated in the power generation module 2 is n·V.

On the other hand, a voltage of n·V is applied to the power storage module 3. Thus, if m power storage devices 11 are series connected, the voltage applied to one power storage device 11 is n·V/m.

Here, the power storage device 11 may include the electrode section 12, the electrode section 13, the sealing section 14, the power storage section 15, the electrolyte 16, and the reducing section 18. The power storage section 15 may include a material having power storage capability such as WO₃. In this case, the voltage required to store electrical power in the power storage section 15 is typically lower than the voltage of the electrical power converted by the power generation section 4.

Furthermore, if an excessive voltage is applied to the power storage device 11, the current flowing through the series connected power storage devices 11 is made larger. This contrarily deteriorates the efficiency of the photovoltaic system 1.

In this case, the number m of power storage devices 11 provided in the power storage module 3 can be made larger than the number n of power generation sections 4 provided in the power generation module 2 (m>n). Then, the voltage applied to the power storage device 11 (n·V/m) can be made lower than V.

That is, the voltage applied to the power storage device 11 can be made lower than the voltage of the electrical power converted by the power generation section 4. This can optimize the voltage applied to the power storage device 11.

Furthermore, the output voltage of the power storage device 11 upon stoppage of irradiation with light L such as sunlight is made comparable to the voltage required to store electrical power in the power storage section 15.

Thus, preferably, the voltage applied to the power storage device 11 is made slightly larger than the voltage required to store electrical power in the power storage section 15.

In the case where the number m of power storage devices 11 provided in the power storage module 3 is made larger than the number n of power generation sections 4 provided in the power generation module 2 (m>n), specific values of the number m of power storage devices 11 and the number n of power generation sections 4 may be determined by considering the I-V characteristics illustrated in FIG. 8 and the drop of output voltage illustrated in FIG. 9.

In other words, the voltage applied to the power storage device 11 is preferably lower than the voltage of the electrical power generated by the power generation section 4. In the case of satisfying such relationship, the power storage function can be achieved irrespective of m>n.

The power storage device 11 illustrated above electrochemically stores the electrical power converted in the power generation section 4. However, the power storage device provided in the power storage module is not limited thereto.

For instance, a power storage device 11a capable of storing and generating electrical power can also be realized.

FIG. 10 is a schematic sectional view for illustrating a power storage device 11a capable of storing and generating electrical power.

As shown in FIG. 10, the power storage device 11a includes an electrode section 12, an electrode section 23, a sealing section 14, a power storage section 25, an electrolyte 16, and a reducing section 18.

The electrode section 23 includes a substrate 23a and a conductive section 23b.

The substrate 23a is shaped like a plate and provided opposite to the electrode section 12.

The substrate 23a is formed from a material having translucency and chemical resistance to the electrolyte 16.

The substrate 23a can be formed from e.g. glass.

The conductive section 23b is shaped like a film and provided on the major surface of the substrate 23a on the side opposed to the electrode section 12.

The conductive section 23b is formed from a material having translucency, conductivity, and chemical resistance to the electrolyte 16.

The conductive section 23b can be formed from e.g. ITO, IZO, FTO, SnO₂, InO₃ or the like.

The power storage section 25 is provided on the substrate 23a via the conductive section 23b.

The power storage section 25 carries sensitizing pigments 25a and has power storage capability.

Thus, the power storage section 25 is formed from a material having power storage capability.

The power storage section 25 can be formed from e.g. WO₃.

The power storage section 25 can have a porous structure.

That is, the power storage section 25 can have a configuration similar to that of the aforementioned power storage section 15 and carry sensitizing pigments 25a on the surface.

The thickness dimension of the power storage section 25 can be set to e.g. approximately 30 µm.

For instance, the power storage section 25 can be formed from particles of WO₃ having a diameter dimension of approximately 20 nm stacked to a thickness of approximately 30 µm.

The sensitizing pigment 25a can be appropriately selected so as to have a desired optical absorption band and absorption spectrum. The sensitizing pigment 25a can be e.g. an inorganic pigment such as Ru (ruthenium)-based pigment, or an organic pigment such as coumarin-based pigment.

By the storage battery device 11a as described above, like the aforementioned power storage device 11, part of the electrical power converted in the power generation module 2 can be stored in the power storage section 25.

Furthermore, if the power storage device 11 is irradiated with light L such as sunlight, electrons in the sensitizing pigment 25a are excited. The excited electrons are extracted as a DC current through the power storage section 25 and the conductive section 23b.

That is, the power storage device 11a can perform power storage and power generation.

Such a power storage device 11a capable of storing and generating electrical power can be provided in the photovoltaic system 1 instead of the power storage device 11.

In this case, even if the power storage device 11a is used, a photovoltaic system having superior I-V characteristics and being capable of suppressing the drop of output voltage upon stoppage of irradiation with light can be realized.

In the case where the power storage device 11a capable of storing and generating electrical power is provided in the power storage module, the power generation module and the power storage module are laid out so as to be irradiated with light L such as sunlight.

The embodiments described above can realize a photovoltaic system and a power storage device having superior I-V characteristics and being capable of suppressing the drop of output voltage upon stoppage of irradiation with light.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention. Moreover, above-mentioned embodiments can be combined mutually and can be carried out.

## Claims

1. A photovoltaic system comprising:
a power generation module including at least one power generation section configured to convert energy of light to electrical power; and
a power storage module including a plurality of power storage devices configured to store the electrical power converted by the power generation section,
the power generation module and the power storage module being connected in parallel,
in the power storage module, the plurality of power storage devices being connected in series, and
number of the power storage devices being larger than number of the power generation sections.

2. The system according to claim 1, wherein the power storage device includes:
a first electrode section;
a second electrode section provided opposite to the first electrode section;
a sealing section provided between the first electrode section and the second electrode section and configured to seal a peripheral portion of the first electrode section and a peripheral portion of the second electrode section;
an electrolyte provided inside the sealing section; and
a power storage section provided inside the sealing section on a surface of the second electrode section on a side opposed to the first electrode section.

3. The system according to claim 2, wherein the power storage section includes tungsten oxide.

4. The system according to claim 1, wherein the power generation module includes a plurality of power generation sections, and the plurality of power generation sections are connected in series.

5. The system according to claim 1, wherein voltage applied to the power storage device is lower than voltage of the electrical power converted by the power generation section.

6. The system according to claim 1, wherein
the power generation module and the power storage module are stacked, and
the power generation module is provided on a side irradiated with light.

7. The system according to claim 2, further comprising:
a sensitizing pigment carried on the power storage section.

8. The system according to claim 7, wherein the power generation module and the power storage module are irradiated with light.

9. The system according to claim 2, wherein the power storage section has a porous structure.

10. A power storage device comprising:
a first electrode section;
a second electrode section provided opposite to the first electrode section;
a sealing section provided between the first electrode section and the second electrode section and configured to seal a peripheral portion of the first electrode section and a peripheral portion of the second electrode section;
an electrolyte provided inside the sealing section;
a power storage section provided inside the sealing section on a surface of the second electrode section on a side opposed to the first electrode section; and
a protecting section provided between the power storage section and the second electrode section,
the power storage section including tungsten oxide, and
the protecting section including carbon.

11. A photovoltaic system comprising:
a power generation module including at least one power generation section configured to convert energy of light to electrical power; and
a power storage module including a plurality of power storage devices configured to store the electrical power converted by the power generation section,
the power generation module and the power storage module being connected in parallel,
in the power storage module, the plurality of power storage devices being connected in series, and
voltage applied to the power storage device being lower than voltage of the electrical power converted by the power generation section.
